# EUROPEAN PATENT APPLICATION

(11) **EP 4 753 092 A1**
(43) Date of publication of application: **03.06.2026**
(21) Application number: 24917243.8
(22) Date of filing: 31.12.2024
(51) Int. Cl.: H02H 7/26, H02H 3/08, G01R 31/52, G01R 31/40

(54) **SYSTEM CONTROL APPARATUS FOR POWER SYSTEM, AND CONTROL METHOD THEREOF**

(30) Priority: 10.01.2024 KR 20240004293; 27.12.2024 KR 20240198087
(71) Applicant: LG Energy Solution, Ltd., Seoul 07335 (KR)
(72) Inventor: KIM, Myung-Hwan, Daejeon 34122 (KR); RYU, Je-Chang, Daejeon 34122 (KR); KIM, Seung-Choo, Daejeon 34122 (KR)
(74) Representative: Goddar, Heinz J.
(86) International application number: PCT/KR2024/021571
(87) International publication number: WO 2025/150754

(57) **Abstract**

There are provided a system control apparatus for a power system and a control method thereof. The system control apparatus includes a main protector installed in a main power channel, first to n-th sub-protectors installed in first to n-th secondary power channels, respectively, and a controller to determine a location of occurrence of a short circuit by controlling at least one of the main protector and the first to n-th sub-protectors when it is determined that the short circuit has occurred in the power system based on a measurement value of a current flowing in the main power channel. n is a natural number of 2 or greater.

## Description

### TECHNICAL FIELD

The present disclosure relates to detection of a short circuit in a power system and protection of the power system from the short circuit.

This application is based on and claims priority from Korean Patent Application No. 10-2024-0004293 filed on January 10, 2024 and Korean Patent Application No. 10-2024-0198087 filed on December 27, 2024, with the Korean Intellectual Property Office, the disclosures of which are incorporated herein in its entirety by reference.

### BACKGROUND

Recently, there has been a rapid increase in the demand for portable electronic products such as laptop computers, video cameras and mobile phones, and with the increasing development of electric vehicles, accumulators for energy storage, robots and satellites, many studies are being made on high performance batteries that can be repeatedly charged and discharged.

Current commercially available batteries include nickel-cadmium batteries, nickel-hydrogen batteries, nickel-zinc batteries, lithium batteries and the like, and among them, lithium batteries have little or no memory effect compared to nickel-based batteries, and thus they are attracting attention for their advantages that recharging can be done whenever it is convenient, the self-discharge rate is very low and the energy density is high.

A battery activation process usually takes a few hours to a few days because an individual charging/discharging procedure for a plurality of batteries is performed by a plurality of chargers/dischargers in a repeated manner according to a predetermined activation schedule.

To properly supply the required power for a plurality of electrical loads such as the chargers/dischargers used in the battery activation process, a power system is needed. The power system has a hierarchical relationship between a main power conversion facility and a plurality of sub-power conversion facilities used to supply the power to the plurality of electrical loads through a large number of power channels.

Meanwhile, short circuits may occur in the power system for many reasons such as aging power lines or operator mistakes. When a short circuit occurs, a flow of large current may cause damage to equipment or human injuries such as electric shocks.

To prevent dangers of short circuits, fuses are installed in power channels. The fuses are blown by a flow of current above a predetermined level through the power channels where they are installed. However, the blown fuses cannot be recovered and need to be replaced with new ones, so the power system is completely stopped until the replacement is completed, and it takes a long time to replace the fuses. Moreover, in the event of a short circuit in the power system, an operator finds where the short circuit occurred with the naked eye because there is no approach to immediately identifying the location of the short circuit.

### DISCLOSURE

### Technical Problem

The present disclosure is designed to solve the above-described problems, and therefore the present disclosure is directed to providing a system control apparatus for identifying the location of occurrence of a short circuit in the event of the short circuit in a power system including a main power conversion facility and a plurality of sub-power conversion facilities having a hierarchical relationship and a control method thereof.

The present disclosure is further directed to providing a system control apparatus that removes risk factors of the short circuit by shutting off a flow of current between each sub-power conversion facility belonging to an electrical area in which the short circuit occurred and the main power conversion facility and a control method thereof.

The present disclosure is further directed to providing a system control apparatus that enable parts of the power system to operate even in a situation where the short circuit has not been fixed by allowing the current to flow between each sub-power conversion facility belonging to an electrical area in which the short circuit did not occur and the main power conversion facility and a control method thereof.

These and other objectives and advantages of the present disclosure may be understood from the following description and will become apparent from the embodiments of the present disclosure. Also, it will be easily understood that the objectives and advantages of the present disclosure may be realized by the means set forth in the appended claims and a combination thereof.

### Technical Solution

A system control apparatus according to an aspect of the present disclosure is provided for a power system. The power system includes a main power conversion facility, first to n-th sub-power conversion facilities connected to the main power conversion facility through first to n-th primary power channels branched from a main power channel, and first to n-th electrical loads connected to the first to n-th sub-power conversion facilities through first to n-th secondary power channels, respectively. n is a natural number of 2 or greater.

The system control apparatus includes a main protector installed in the main power channel, first to n-th sub-protectors installed in the first to n-th secondary power channels, respectively, and a controller to determine a location of occurrence of a short circuit by controlling at least one of the main protector and the first to n-th sub-protectors when it is determined that the short circuit has occurred in the power system based on a measurement value of a current flowing in the main power channel.

The controller may control the main protector to shut off the flow of current in the main power channel when it is determined that the short circuit has occurred in the power system.

The controller may control the main power conversion facility and the first to n-th sub-power conversion facilities into an OFF-state when it is determined that the short circuit has occurred in the power system.

When it is determined that the short circuit has occurred in the power system, the controller may control the main protector to apply an electric stimulus to the main power channel. The controller may determine whether the location of occurrence of the short circuit exists in an i-th electrical area from an i-th primary power channel to an i-th electrical load based on the measurement value of the current flowing in an i-th secondary power channel while the electrical stimulus is applied to the main power channel. i is a natural number that is equal to or smaller than n.

The controller may determine that the i-th sub-power conversion facility is where the short circuit has occurred when the measurement value of the current flowing in the main power channel is equal to or larger than a threshold value and the measurement value of the current flowing in the i-th secondary power channel is less than the threshold value.

The controller may disallow operation of the i-th sub-power conversion facility when it is determined that the i-th sub-power conversion facility is where the short circuit has occurred.

The controller may determine that the i-th electrical load is where the short circuit has occurred when the measurement value of the current flowing in the main power channel is equal to or larger than a threshold value and the measurement value of the current flowing in the i-th secondary power channel is equal to or larger than the threshold value.

The controller may control an i-th sub-protector to shut off the flow of current in the i-th secondary power channel when it is determined that the i-th electrical load is where the short circuit has occurred.

The controller may control, into an ON-state, the sub-power conversion facility of each electrical area determined that the location of occurrence of the short circuit does not exist, among the first to n-th electrical areas.

The main protector may include a main current sensor to detect the current flowing through the main power channel, and a main switch to open and close the flow of current in the main power channel.

An i-th sub-protector may include an i-th sub-current sensor to detect the current flowing through an i-th secondary power channel, and an i-th sub-switch to open and close the flow of current in the i-th secondary power channel. i is a natural number that is equal to or smaller than n.

A power system according to another aspect of the present disclosure includes a main power conversion facility, first to n-th sub-power conversion facilities connected to the main power conversion facility through first to n-th primary power channels branched from a main power channel, first to n-th electrical loads connected to the first to n-th sub-power conversion facilities through first to n-th secondary power channels, respectively, and the system control apparatus.

A control method of a system control apparatus according to still another aspect of the present disclosure is provided for a power system including a main power conversion facility, first to n-th sub-power conversion facilities connected to the main power conversion facility through first to n-th primary power channels branched from a main power channel, and first to n-th electrical loads connected to the first to n-th sub-power conversion facilities through first to n-th secondary power channels, respectively. The control method includes determining, by the controller of the system control apparatus, whether a short circuit has occurred in the power system based on a measurement value of a current flowing in the main power channel, and determining, by the controller, a location of occurrence of the short circuit by controlling at least one of the main protector and the first to n-th sub-protectors when it is determined that the short circuit has occurred in the power system. n is a natural number of 2 or greater.

The determining of the location of occurrence of the short circuit in the power system may include controlling, by the controller, the main protector to apply an electrical stimulus to the main power channel, and determining whether the location of occurrence of the short circuit exists in an i-th electrical area from an i-th primary power channel to an i-th electrical load based on the measurement value of the current flowing in an i-th secondary power channel while the electrical stimulus is applied to the main power channel. i is a natural number that is equal to or smaller than n.

The control method may further include controlling, into an ON-state, the sub-power conversion facility of each electrical area determined that the location of occurrence of the short circuit does not exist, among the first to n-th electrical areas.

### Advantageous Effects

According to at least one of the embodiments of the present disclosure, it may be possible to automatically identify a location of occurrence of a short circuit in the power system including the main power conversion facility and the plurality of sub-power conversion facilities having a hierarchical relationship.

In addition, according to at least one of the embodiments of the present disclosure, it may be possible to remove the risk factors of the short circuit by shutting off a flow of current between each sub-power conversion facility belonging to an electrical area in which the short circuit occurred and the main power conversion facility.

In addition, according to at least one of the embodiments of the present disclosure, it may be possible to perform control so as to enable parts of the power system to operate even in a situation where the short circuit has not been fixed by allowing the current to flow between each sub-power conversion facility belonging to an electrical area in which the short circuit did not occur and the main power conversion facility.

The effects of the present disclosure are not limited to the aforementioned effects, and these and other effects will be clearly understood by those skilled in the art from the appended claims.

### BRIEF DESCRIPTION OF THE DRAWINGS

The accompanying drawings illustrate exemplary embodiments of the present disclosure and together with the following detailed description, serve to provide a better understanding of the technical aspects of the present disclosure, and thus the present disclosure should not be constructed as being limited to the drawings.
FIG. 1 is a diagram schematically showing the entire architecture of a power system according to an embodiment of the present disclosure.
FIG. 2 schematically shows the detailed configuration of a main protector shown in FIG. 1.
FIG. 3 schematically shows the detailed configuration of a sub-protector shown in FIG. 1.
FIGS. 4 to 6 are diagrams referenced in describing a short circuit that may occur in a power system.
FIG. 7 is a flowchart schematically showing a control method of a system control apparatus according to another embodiment of the present disclosure.
FIG. 8 is a flowchart referenced in describing the detailed procedure of step S730 in FIG. 7.

### BEST MODE

Hereinafter, exemplary embodiments of the present disclosure will be described in detail with reference to the accompanying drawings. Prior to the description, it should be understood that the terms or words used in the specification and the appended claims should not be construed as being limited to general and dictionary meanings, and rather, should be interpreted based on the meanings and concepts corresponding to the technical aspects of the present disclosure on the basis of the principle that the inventor is allowed to define the terms appropriately for the best explanation.

Therefore, the embodiments described herein and the illustrations shown in the drawings are exemplary embodiments of the present disclosure to describe the technical aspects of the present disclosure but not intended to be limiting, so it should be understood that a variety of other equivalents and modifications could have been made thereto at the time the application was filed.

The terms "first", "second" and the like, are used to distinguish one element from another among various elements, but not intended to limit the elements by the terms.

Unless the context clearly indicates otherwise, "comprise" and "include" when used in this specification, specify the presence of stated elements, but do not preclude the presence or addition of one or more other elements. Additionally, the term "unit" as used herein refers to a processing unit of at least one function or operation, and may be implemented by hardware and software either alone or in combination.

In addition, throughout this specification, it will be further understood that when an element is referred to as being "connected to" another element, it can be directly connected to the other element or intervening elements may be present.

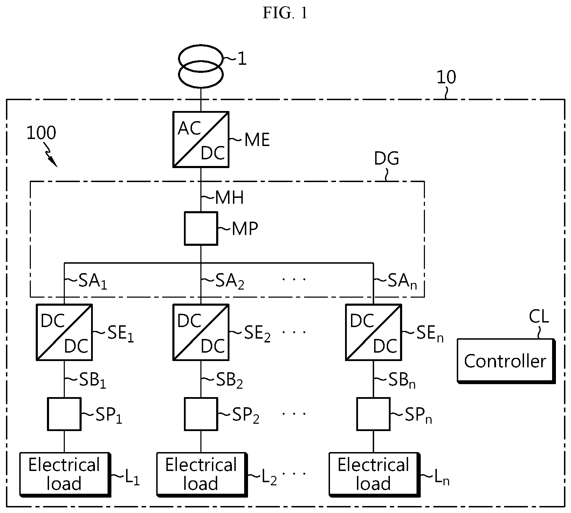

FIG. 1 is a diagram schematically showing the entire architecture of a direct current (DC) distribution-based power system 10 according to an embodiment of the present disclosure.

Referring to FIG. 1, the power system 10 includes a main power conversion facility ME, a DC grid DG and first to n-th sub-power conversion facilities SE₁~SEₙ. n is a natural number of 2 or greater. The power system 10 may further include a system control apparatus 100.

An input terminal of the main power conversion facility ME may be electrically connected to an alternating current (AC) power grid 1. The main power conversion facility ME may convert AC power from the AC power grid 1 to DC power and output it to a DC grid DG.

The voltage of the DC power from the main power conversion facility ME may be maintained at a predetermined reference voltage (for example, 370[V]) by feedback control. The main power conversion facility ME may include at least one unidirectional AC-DC converter and/or at least one bidirectional AC-DC converter.

The DC grid DG may include a main power channel MH and first to n-th primary power channels SA₁~SAₙ. The first to n-th primary power channels SA₁~SAₙ are power lines branched from the main power channel MH, and one end of each of the first to n-th primary power channels SA₁~SAₙ is electrically connected to one end of the main power channel MH.

The first to n-th sub-power conversion facilities SE₁~SEₙ may be individually connected to the main power conversion facility ME through the DC grid DG.

When it is assumed that i is a natural number equal to or smaller than n, a series circuit of an i-th primary power channel SAᵢ of the DC grid DG and the main power channel MH connects an input terminal of an i-th sub-power conversion facility SEᵢ and an output terminal of the main power conversion facility ME. The i-th sub-power conversion facility SEᵢ may include at least one unidirectional DC-DC converter and/or at least one bidirectional DC-DC converter.

The DC power from the main power conversion facility ME may be supplied to the first to n-th sub-power conversion facilities SE₁~SEₙ through the DC grid DG. While it is controlled into an ON-state, the i-th sub-power conversion facility SEᵢ may convert the DC power supplied from the main power conversion facility ME to DC power having a different voltage level. From this point of view, it may be said that the main power conversion facility ME and the first to n-th sub-power conversion facilities SE₁~SEₙ have a hierarchical relationship.

First to n-th electrical loads L₁~Lₙ may be electrically connected to the first to n-th sub-power conversion facilities SE₁~SEₙ through first to n-th secondary power channels SB₁~SBₙ, respectively. The power system 10 may further include the first to n-th electrical loads L₁~Lₙ.

An i-th electrical load Lᵢ may perform its unique function by using the DC power supplied from the i-th sub-power conversion facility SEᵢ. The first to n-th secondary power channels SB₁~SBₙ may be included in the power system 10.

Each of the main power channel MH, the first to n-th primary power channels SA₁~SAₙ and the first to n-th secondary power channels SB₁~SBₙ may include a pair of electrical lines. One of the pair of electrical lines may be a plus line and the other may be a minus line.

The first to n-th sub-power conversion facilities SE₁~SEₙ may be electrically connected to each other through the DC grid DG.

The system control apparatus 100 may include a main protector MP, first to n-th sub-protectors SP₁~SPₙ and a controller CL.

The controller CL may be operably coupled to the main protector MP and the first to n-th sub-protectors SP₁~SPₙ. The operably coupled refers to direct/indirect connection to enable signal transmission and reception in one or two directions. Although not shown in FIG. 1, the main protector MP and the first to n-th sub-protectors SP₁~SPₙ may be individually coupled to the controller CL through communication lines.

The main protector MP may be installed in the main power channel MH.

The first to n-th sub-protectors SP₁~SPₙ may be individually installed in the first to n-th secondary power channels SB₁~SBₙ.

The controller CL may control the main power conversion facility ME into an ON or OFF state according to the operating state of the AC power grid 1, and control the DC power output by the AC-DC converter in ON state.

The controller CL is configured to monitor the condition of at least one of the DC grid DG, the main power conversion facility ME, the first to n-th sub-power conversion facilities SE₁~SEₙ and the first to n-th electrical loads L₁~Lₙ coupled to the controller CL, and perform a control function corresponding to the monitored condition.

The controller CL may include, in hardware, at least one of application specific integrated circuits (ASICs), digital signal processors (DSPs), digital signal processing devices (DSPDs), programmable logic devices (PLDs), field programmable gate arrays (FPGAs), microprocessors or electrical units for performing other functions.

The controller CL may have a memory. The memory may include at least one type of storage medium of flash memory type, hard disk type, Solid State Disk (SSD) type, Silicon Disk Drive (SDD) type, multimedia card micro type, random access memory (RAM), static random access memory (SRAM), read-only memory (ROM), electrically erasable programmable read-only memory (EEPROM) or programmable read-only memory (PROM). The memory may store data and programs required for the computation operation by the controller CL. The memory unit may store data indicating the results of the computation operation by the controller CL.

The controller CL may determine whether an unintended short circuit has occurred in the power system 10 based on a detection value of the current flowing through the main power channel MH and/or the i-th secondary power channel SBᵢ.

When the short circuit in the power system 10 is identified, the controller CL may perform the control function for protecting the power system 10. Specifically, the controller CL may control at least one of the main protector MP and the first to n-th sub-protectors SP₁~SPₙ, and further control at least one of the main power conversion facility ME, the first to n-th sub-power conversion facilities SE₁~SEₙ and the first to n-th electrical loads L₁~Lₙ, according to the result of determining whether the short circuit has occurred.

The controller CL may transmit a first control signal commanding to operate in the ON-state or a second control signal commanding to change from the ON-state to the OFF-state to the i-th sub-power conversion facility SEᵢ. In response to the first control signal, the i-th sub-power conversion facility SEᵢ may supply the DC power to the i-th electrical load Lᵢ through the i-th secondary power channel SBᵢ.

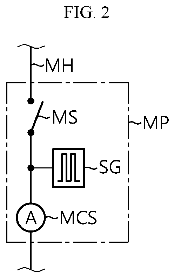

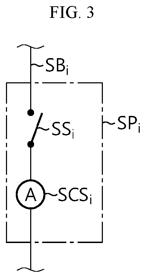

FIG. 2 schematically shows the detailed configuration of the main protector MP shown in FIG. 1, and FIG. 3 schematically shows the detailed configuration of the sub-protector SP shown in FIG. 1.

Referring to FIG. 2, the main protector MP may include a main current sensor MCS and a main switch MS. The main current sensor MCS and the main switch MS may be connected in series. The main switch MS may be located electrically closer to the main power conversion facility ME than the main current sensor MCS.

The main current sensor MCS may detect the current flowing through the main power channel MH. The controller CL may determine whether a short circuit has occurred in the power system 10 based on the detection value of the current detected by the main current sensor MCS.

The main switch MS may open and close the flow of current in the main power channel MH. While the main switch MS is controlled into the ON-state, the main power conversion facility ME may be electrically connected to the i-th sub-power conversion facility SEᵢ. While the main switch MS is controlled into the OFF-state, the main power conversion facility ME may be electrically separated from the i-th sub-power conversion facility SEᵢ.

The main protector MP may further include a stimulus generator SG.

The stimulus generator SG is configured to generate an electrical stimulus in response to the operation command from the controller CL. When it is determined that a short circuit has occurred in the power system 10, the controller CL may transmit the operation command triggering the generation of an electrical stimulus to the stimulus generator SG.

The electrical stimulus generated by the stimulus generator SG may be applied between the plus line and the minus line of the main power channel MH. For example, the electrical stimulus may be a voltage pulse signal. The voltage level of the voltage pulse signal may lie in a predetermined voltage range. The duty ratio of the voltage pulse signal may be preset.

Referring to FIG. 3, the i-th sub-protector SPᵢ may include an i-th sub-current sensor SCSᵢ and an i-th sub-switch SSᵢ. The i-th sub-current sensor SCSi and the i-th sub-switch SSᵢ may be connected in series. The i-th sub-switch SSᵢ may be located electrically closer to the i-th sub-power conversion facility SEᵢ than the i-th sub-current sensor SCSᵢ.

The i-th sub-current sensor SCSᵢ may detect the current flowing through the i-th secondary power channel SBᵢ. In a situation where it is determined that the short circuit has occurred in the power system 10, the controller CL may determine whether the location of occurrence of the short circuit exists in an i-th electrical area based on the detection value of the current detected by the i-th sub-current sensor SCSᵢ. The i-th electrical area may be at least a part of a power path from the i-th primary power channel SAᵢ to the i-th secondary power channel SBᵢ or from the i-th primary power channel SAᵢ to the i-th electrical load Lᵢ.

The i-th sub-switch SSᵢ may open and close the flow of current in the i-th secondary power channel SBᵢ. While the i-th sub-switch SSᵢ is controlled into the ON-state, the i-th sub-power conversion facility SEᵢ may be electrically connected to the i-th electrical load Lᵢ. While the i-th sub-switch SSᵢ is controlled into the OFF-state, the i-th sub-power conversion facility SEᵢ may be electrically separated from the i-th electrical load Lᵢ.

The controller CL may control the i-th sub-switch SSᵢ into the ON-state while the electrical stimulus is applied to the main power channel MH by the stimulus generator SG.

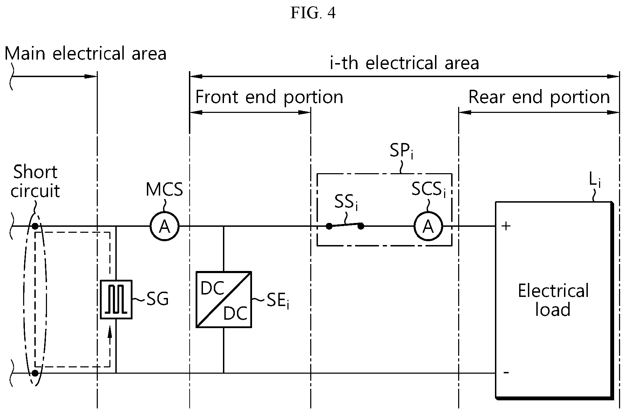

FIGS. 4 to 6 are diagrams referenced in describing the short circuit that may occur in the power system 10.

The short circuit refers to a condition in which two power lines of at least one power channel in the power system 10 are electrically short-circuited for some reasons. The resistance at the location of occurrence of the short circuit is close to 0, and the current may focus on the corresponding location.

FIG. 4 shows a situation where the location of occurrence of the short circuit is within a main electrical area, not the i-th electrical area. The main electrical area may range from a predetermined point of the main power channel MH to the stimulus generator SG. In this case, most of the current triggered by the electrical stimulus applied by the stimulus generator SG does not flow to the i-th electrical area and intensively flows in the main electrical area. That is, most of the current triggered by the electrical stimulus may flow in a closed circuit (see the dotted arrow line) including the location of the short circuit, the two power lines of the main power channel MH and the stimulus generator SG. As a result, there may be no or little change in the current detected by each of the main current sensor MCS and the i-th sub-current sensor SCSᵢ before and after the application of the electrical stimulus by the stimulus generator SG.

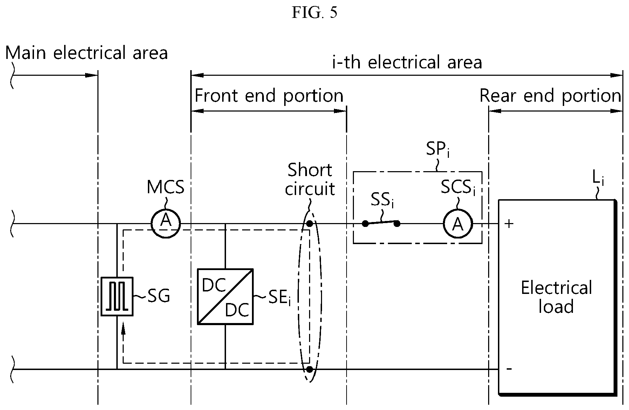

FIG. 5 shows a situation where the location of occurrence of the short circuit is within a front end portion of the i-th electrical area. The front end portion of the i-th electrical area may range from the front end of the i-th primary power channel SAᵢ (a point of connection with the main power channel ) to the front end of the i-th sub-protector SPᵢ (i.e., the front end of the i-th secondary power channel). The short circuit within the front end portion of the i-th electrical area may be simply referred to as a short circuit in the i-th sub-power conversion facility SEᵢ. In this case, most of the current triggered by the electrical stimulus applied by the stimulus generator SG intensively flows in the front end portion of the i-th electrical area. That is, most of the current triggered by the electrical stimulus may flow in a closed circuit (see the dotted arrow line) including the location of the short circuit (for example, the input or output terminal of the i-th sub-power conversion facility), the two power lines of the i-th secondary power channel SBᵢ, the main current sensor MCS and the stimulus generator SG. As a result, when the electrical stimulus is applied by the stimulus generator SG, a change in the current detected by the main current sensor MCS may be much larger than a change in the current detected by the i-th sub-current sensor SCSᵢ.

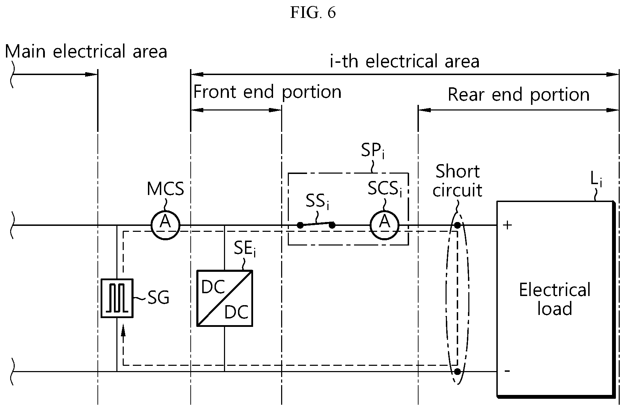

FIG. 6 shows a situation where the location of occurrence of the short circuit is within a rear end portion of the i-th electrical area. The rear end portion of the i-th electrical area may range from the rear end of the i-th sub-protector SPᵢ (i.e., the rear end of the i-th secondary power channel) to the i-th electrical load Lᵢ. The short circuit within the rear portion of the i-th electrical area may be simply referred to as a short circuit in the i-th electrical load Lᵢ. In this case, most of the current triggered by the electrical stimulus applied by the stimulus generator SG flows to the front end portion of the i-th electrical area as well as the rear end portion. That is, most of the current triggered by the electrical stimulus may flow in a closed circuit (see the dotted arrow line) including the location of the short circuit (for example, the input terminal of the i-th electrical load or the inside of the i-th electrical load), the two power lines of the i-th secondary power channel SBᵢ, the main current sensor MCS, the i-th sub-current sensor SCSᵢ and the stimulus generator SG. As a result, when the electrical stimulus is applied by the stimulus generator SG, both the current detected by the main current sensor MCS and the current detected by the i-th sub-current sensor SCSᵢ may greatly change.

As described above with reference to FIGS. 4 to 6, it will be easily apparent to those skilled in the art that the amount of current change detected by each of the main current sensor MCS and the i-th sub-current sensor SCSᵢ relies on the location of occurrence of the short circuit, specifically, the main power channel MH, the front end portion of the i-th electrical area and the rear end portion of the i-th electrical area.

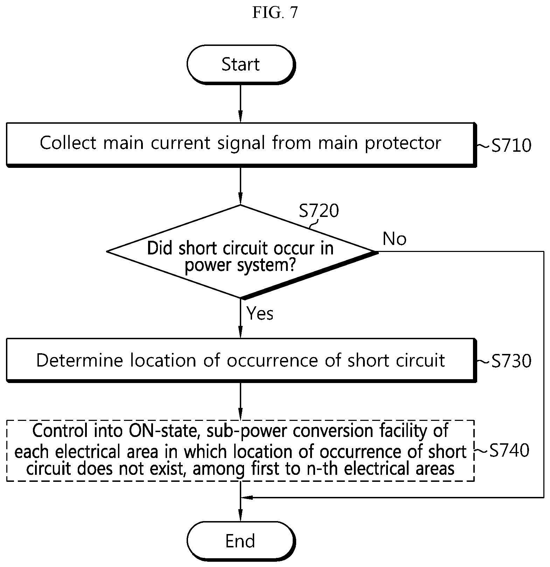

FIG. 7 is a flowchart schematically showing a control method of the system control apparatus 100 according to another embodiment of the present disclosure. The method of FIG. 7 may be performed periodically or aperiodically in a repeated manner on the condition that the power system 10 is in operation. During the operation of the power system 10, the main switch MS of the main protector MP is controlled into the ON-state. The operation of the power system 10 may refer to a condition in which the main power conversion facility ME supplies the power to at least one of the first to n-th electrical loads L₁~Lₙ.

Referring to FIGS. 1 to 7, in step S710, the controller CL collects a main current signal from the main protector MP. The main current signal indicates a measurement value of the current flowing in the main power channel MH.

In step S720, the controller CL determines whether a short circuit has occurred in the power system 10. For example, when the measurement value of the current flowing in the main power channel MH is larger than a first predetermined set value, it may be determined that a short circuit exists in the power system 10. As another example, when a change ratio of the current flowing in the main power channel MH is larger than a second predetermined set value due to a rapid increase or decrease in the current flowing in the main power channel MH, it may be determined that a short circuit exists in the power system 10. When a value of the step S720 is "Yes", step S730 may be performed. When the value of the step S720 is "No", the method of FIG. 7 may be terminated. Optionally, when the value of the step S720 is "Yes", the controller CL may control at least one of the main power conversion facility ME or the main switch MS into the OFF-state. Additionally, when the value of the step S720 is "Yes", the controller CL may control at least one of the first to n-th sub-power conversion facilities SE₁~SEₙ into the OFF-state.

In the step S730, the controller CL determines the location of occurrence of the short circuit by controlling the main protector MP and the first to n-th sub-protectors SP₁~SPₙ. When it is determined that the location of occurrence of the short circuit is within the main electrical area at the step S730, the controller CL may disallow operation of the main power conversion facility ME, and further disallow operation of the first to n-th sub-power conversion facilities SE₁~SEₙ.

In step S740, the controller Cl controls, into the ON state, the sub-power conversion facility of each electrical area in which the location of occurrence of the short circuit does not exist, among the first to n-th electrical areas. The step S740 is optional in the method according to FIG. 7, and may be included in the method according to FIG. 7 or omitted as needed.

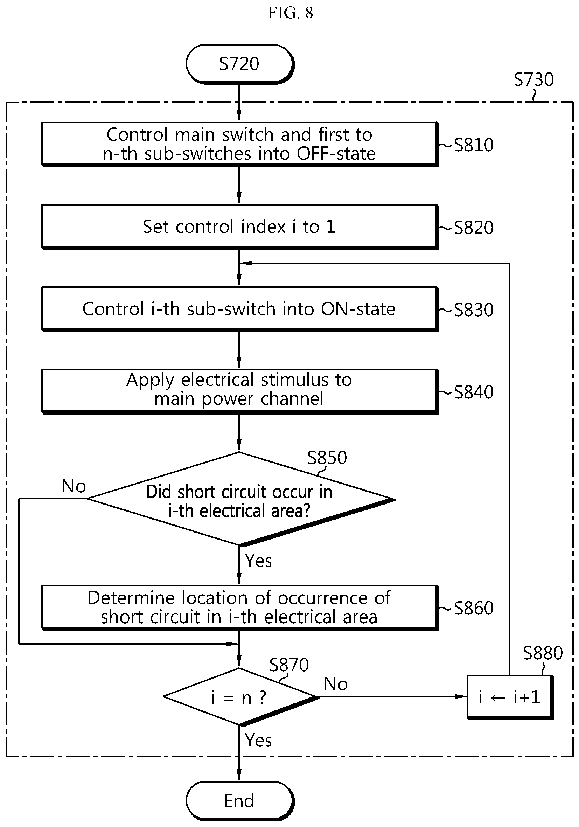

FIG. 8 is a flowchart referenced in describing the detailed procedure of the step S730 in FIG. 7.

Referring to FIG. 8, in step S810, the controller CL controls the main switch MS and the first to n-th sub-switches SS₁~SSₙ into the OFF state.

In step S820, the controller CL sets a control index i to 1.

In step S830, the controller CL controls the i-th sub-switch SSᵢ into the ON-state.

In step S840, the controller CL controls the stimulus generator SG to apply an electrical stimulus to the main power channel MH.

In step S850, the controller CL determines whether the short circuit has occurred in the i-th electrical area based on the main current signal collected from the main protector MP. That is, it may be determined whether the location of occurrence of the short circuit is inside or outside of the i-th electrical area at the step S850.

As an example, during the application of the electrical stimulus, the controller CL may determine that the short circuit has occurred in the i-th electrical area when the measurement value (size) of the current flowing in the main power channel MH is equal to or larger than a first threshold value, or the change (size) in the measurement value of the current flowing in the main power channel MH is equal to or larger than a second threshold value.

As another example, during the application of the electrical stimulus, the controller CL may determine that the short circuit has occurred in the main electrical area, not the i-th electrical area when the measurement value of the current flowing in the main power channel MH is less than the first threshold value, or the change in the measurement value of the current flowing in the main power channel MH is less than the second threshold value.

When a value of the step S850 is "Yes", step S860 may be performed. When the value of the step S850 is "No", step S880 may be performed. For reference, after the end of the step S850, the controller CL may control the i-th sub-switch SSᵢ into the OFF state. In addition, when the value of the step S850 is "Yes", the controller CL may disallow operation of the i-th sub-power conversion facility SEᵢ (i.e., maintained in the OFF state).

In step S860, the controller CL determines the location of occurrence of the short circuit in the i-th electrical area based on the i-th sub-current signal collected from the i-th sub-protector SPᵢ.

As an example, during the application of the electrical stimulus, the controller CL may determine that the short circuit has occurred in a portion of the i-th electrical area (for example, the front end portion of the i-th electrical area) where the i-th sub-power conversion facility SEᵢ belongs but the i-th electrical load Lᵢ does not belong, when the measurement value of the current flowing in the i-th secondary power channel SBᵢ is less than a third threshold value or the change in the measurement value of the current flowing in the i-th secondary power channel SBᵢ is less than a fourth threshold value.

As another example, during the application of the electrical stimulus, the controller CL may determine that the short circuit has occurred in a portion of the i-th electrical area (for example, the rear end portion of the i-th electrical area) where the i-th sub-power conversion facility SEᵢ does not belong but the i-th electrical load Lᵢ belongs, when the measurement value of the current flowing in the i-th secondary power channel SBᵢ is equal to or larger than the third threshold value or the change in the measurement value of the current flowing in the i-th secondary power channel SBᵢ is equal to or larger than the fourth threshold value. The third threshold value may be equal to the first threshold value. The fourth threshold value may be equal to the second threshold value.

In step S870, the controller CL determines whether the control index i is equal to n. When a value of the step S870 is "Yes", the method according to FIG. 8 may be terminated. When the value of the step S870 is "No", step S880 may be performed.

In the step S880, the controller CL increases the control index i by 1. After the step S880, the method according to FIG. 8 may return to the step S830.

Although FIG. 8 shows that the control index i changes from 1 to n in an ascending order, this is provided by way of example. Accordingly, the control index i may change from n to 1 in a descending order, or the determination as to whether the short circuit has occurred or not and where the short circuit has occurred for each of the first to n-th electrical areas may be made in a preset order.

The embodiments of the present disclosure as described above are not embodied only through an apparatus and method, and may be implemented through programs that perform the functions corresponding to the exemplary configurations of the present disclosure or recording media having the programs recorded thereon, and such implementation may be easily achieved by those skilled in the art from the disclosure of the embodiments previously described.

Although the present disclosure has been hereinabove described with regard to certain embodiments and drawings, the present disclosure is not limited thereto and it is obvious to those skilled in the art that various modifications and changes may be made thereto within the technical aspects of the present disclosure and the scope of the appended claims and their equivalents.

Additionally, as many substitutions, modifications and changes may be made to the present disclosure as described above by those skilled in the art without departing from the technical aspects of the present disclosure, the present disclosure is not limited by the above-described embodiments and the accompanying drawings, and some or all of the embodiments may be selectively combined to allow various modifications.

## Claims

1. A system control apparatus for a power system including a main power conversion facility, first to n-th sub-power conversion facilities connected to the main power conversion facility through first to n-th primary power channels branched from a main power channel, and first to n-th electrical loads connected to the first to n-th sub-power conversion facilities through first to n-th secondary power channels, respectively, the system control apparatus comprising:
a main protector installed in the main power channel;
first to n-th sub-protectors installed in the first to n-th secondary power channels, respectively; and
a controller to determine a location of occurrence of a short circuit by controlling at least one of the main protector and the first to n-th sub-protectors when it is determined that the short circuit has occurred in the power system based on a measurement value of a current flowing in the main power channel,
wherein n is a natural number of 2 or greater.

2. The system control apparatus according to claim 1,
wherein the controller is configured to:
control the main protector to shut off the flow of current in the main power channel when it is determined that the short circuit has occurred in the power system.

3. The system control apparatus according to claim 1,
wherein the controller is configured to:
control the main power conversion facility and the first to n-th sub-power conversion facilities into an OFF-state when it is determined that the short circuit has occurred in the power system.

4. The system control apparatus according to claim 1,
wherein the controller is configured to:
when it is determined that the short circuit has occurred in the power system,
control the main protector to apply an electric stimulus to the main power channel, and
determine whether the location of occurrence of the short circuit exists in an i-th electrical area from an i-th primary power channel to an i-th electrical load based on the measurement value of the current flowing in an i-th secondary power channel while the electrical stimulus is applied to the main power channel,
wherein i is a natural number that is equal to or smaller than n.

5. The system control apparatus according to claim 4,
wherein the controller is configured to:
determine that the i-th sub-power conversion facility is where the short circuit has occurred when the measurement value of the current flowing in the main power channel is equal to or larger than a threshold value and the measurement value of the current flowing in the i-th secondary power channel is less than the threshold value.

6. The system control apparatus according to claim 5,
wherein the controller is configured to:
disallow operation of the i-th sub-power conversion facility when it is determined that the i-th sub-power conversion facility is where the short circuit has occurred.

7. The system control apparatus according to claim 4,
wherein the controller is configured to:
determine that the i-th electrical load is where the short circuit has occurred when the measurement value of the current flowing in the main power channel is equal to or larger than a threshold value and the measurement value of the current flowing in the i-th secondary power channel is equal to or larger than the threshold value.

8. The system control apparatus according to claim 7,
wherein the controller is configured to:
control an i-th sub-protector to shut off the flow of current in the i-th secondary power channel when it is determined that the i-th electrical load is where the short circuit has occurred.

9. The system control apparatus according to claim 4,
wherein the controller is configured to:
control, into an ON-state, a sub-power conversion facility of each electrical area determined that the location of occurrence of the short circuit does not exist, among the first to n-th electrical areas.

10. The system control apparatus according to claim 1,
wherein the main protector includes:
a main current sensor to detect the current flowing through the main power channel; and
a main switch to open and close the flow of current in the main power channel.

11. The system control apparatus according to claim 1,
wherein an i-th sub-protector includes:
an i-th sub-current sensor to detect the current flowing through an i-th secondary power channel; and
an i-th sub-switch to open and close the flow of current in the i-th secondary power channel, and
wherein i is a natural number that is equal to or smaller than n.

12. A power system comprising:
a main power conversion facility;
first to n-th sub-power conversion facilities connected to the main power conversion facility through first to n-th primary power channels branched from a main power channel;
first to n-th electrical loads connected to the first to n-th sub-power conversion facilities through first to n-th secondary power channels, respectively; and
the system control apparatus according to any one of claims 1 to 11.

13. A control method of a system control apparatus for a power system including a main power conversion facility, first to n-th sub-power conversion facilities connected to the main power conversion facility through first to n-th primary power channels branched from a main power channel, and first to n-th electrical loads connected to the first to n-th sub-power conversion facilities through first to n-th secondary power channels, respectively, the control method comprising:
determining, by the controller of the system control apparatus, whether a short circuit has occurred in the power system based on a measurement value of a current flowing in the main power channel; and
determining, by the controller, a location of occurrence of the short circuit by controlling at least one of the main protector and the first to n-th sub-protectors when it is determined that the short circuit has occurred in the power system,
wherein n is a natural number of 2 or greater.

14. The control method according to claim 13,
wherein the determining of the location of occurrence of the short circuit in the power system comprises:
controlling, by the controller, the main protector to apply an electrical stimulus to the main power channel; and
determining whether the location of occurrence of the short circuit exists in an i-th electrical area from an i-th primary power channel to an i-th electrical load based on the measurement value of the current flowing in an i-th secondary power channel while the electrical stimulus is applied to the main power channel,
wherein i is a natural number that is equal to or smaller than n.

15. The control method according to claim 13, further comprising:
controlling, into an ON-state, the sub-power conversion facility of each electrical area determined that the location of occurrence of the short circuit does not exist, among the first to n-th electrical areas.
